# FASCICULE DE BREVET EUROPEEN

(11) **EP 1 355 187 B1**
(45) Date de publication et mention de la délivrance du brevet: **23.02.2011**
(21) Numéro de dépôt: 02076554.1
(22) Date de dépôt: 19.04.2002
(51) Int. Cl.: G02F 1/13, H05K 3/36, H01R 4/02, B23K 26/24

(54) **Procédé de connexion d'un circuit imprimé à un affichage à cristaux liquides**
Verfahren zum Verbinden einer Leiterplatte mit einer Flüssigkristallanzeige
Process for connection of a printed circuit board to a liquid crystal display

(43) Date de publication de la demande: 22.10.2003
(73) Titulaire: ETA SA Manufacture Horlogère Suisse, 2540 Grenchen (CH)
(72) Inventeur: Durand, Friedrich, 4500 Solothurn (CH); Pfefferli, Beat, 2075 Thielle-Wavre (CH)
(74) Mandataire: Couillard, Yann Luc Raymond

(56) Documents cités:
- US-A- 4 654 965
- US-A- 4 836 651
- US-A- 5 606 440
- PATENT ABSTRACTS OF JAPAN vol. 013, no. 047 (P-822), 3 février 1989 (1989-02-03) & JP 63 241523 A (TOSHIBA CORP), 6 octobre 1988 (1988-10-06)
- "COMPACT LIQUID CRYSTAL DISPLAY MODULE STRUCTURE" IBM TECHNICAL DISCLOSURE BULLETIN, IBM CORP. NEW YORK, US, vol. 40, no. 2, 1 février 1997 (1997-02-01), pages 227-228, XP000692230 ISSN: 0018-8689

## Description

La présente invention concerne un procédé de connexion d'un affichage à cristaux liquides sur un circuit imprimé, notamment le circuit imprimé supportant les composants électroniques d'un affichage digital, notamment dans une pièce d'horlogerie.

Un affichage à cristaux liquides (LCD) comporte de façon connue, à l'extérieur du cadre de scellement de deux substrats transparents de même dimension, des pistes permettant de connecter les électrodes de l'affichage à un circuit imprimé (PCB) ayant à la meilleure connaissance de la demanderesse toujours une surface sensiblement plane. Cette connexion est actuellement effectuée au moyen d'un connecteur multipistes de type "Zebra" par soudage, ou par utilisation d'une colle conductrice anisotrope, ou d'une bande ACF (Anisotropie Contacting Foil). De tels procédés sont techniquement tout à fait satisfaisants lorsque le LCD et le PCB sont dans un même plan. Ils sont encore satisfaisants lorsque, par choix ou par nécessité, on place le PCB sous le LCD, avec toutefois le risque d'endommager des pistes du connecteur type "Zebra" si on impose audit connecteur un rayon de courbure trop petit, comme cela pourrait être le cas dans une montre-bracelet à affichage digital ayant un boîtier de très faible épaisseur. Outre le risque évoqué ci-dessus, ces procédés ont également l'inconvénient de consommer des matériaux intermédiaires (Zebra, ACF, etc.) relativement chers et de nécessiter un temps d'exécution relativement long. Cet art antérieur est par exemple illustré par les brevets US 5 606 440 et US 4 654 965

La présente invention met en oeuvre un procédé de connexion d'un LCD à un PCB, plus rapide, plus économique et techniquement plus fiable en ce qu'il ne fait pas appel à des matériaux intermédiaires, mais utilise un faisceau laser.

A cet effet l'invention a pour objet un procédé de connexion d'un circuit imprimé (PCB) aux pistes des électrodes d'une cellule d'affichage à cristaux liquides (LCD) tel que défini dans l'unique revendication.

Le procédé selon l'invention ne fait donc plus intervenir aucun matériau intermédiaire et permet de réaliser l'opération de connexion dans un temps plus cours, ce qui contribue à diminuer le prix de revient du produit final.

Selon un exemple non revendiqué la glace supérieure du LCD peut ne comporter qu'une seule extension et le PCB peut être connecté dans le prolongement du LCD et sensiblement dans le même plan.

Selon un mode de réalisation la glace supérieure du LCD comporte au moins deux extensions et le PCB est situé sous le LCD. Dans ce cas le PCB présente avantageusement un évidemment permettant de loger la glace inférieure de façon à ce que les bords de l'évidemment viennent affleurer la surface inférieure de la glace supérieure. Le produit ainsi obtenu est compact et présente de bonnes propriétés mécaniques.

D'autres avantages et caractéristiques de la présente invention apparaîtront plus clairement à la lecture de la description ci-après faite en référence aux dessins annexés dans lesquels
- la figure 1 représente en coupe un exemple non revendiqué et
- la figure 2 représente en coupe un mode de réalisation.

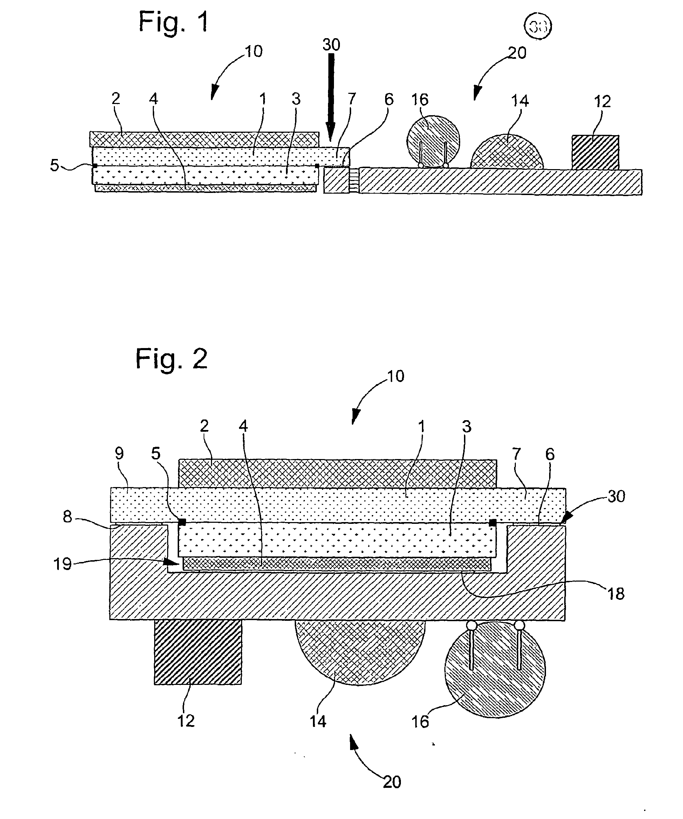

A la figure 1 on a représenté schématiquement en coupe une cellule d'affichage 10 à cristaux liquides (LCD) connectée à un circuit imprimé 20 (PCB) pouvant être réalisé en un matériau souple. La cellule comporte de façon usuelle une glace supérieure 1 à l'avant de laquelle est placé un polariseur 2, une glace inférieure 3, à l'arrière de laquelle est placé un réflecteur 4, et un cadre de scellement 5 délimitant l'espace de confinement des cristaux liquides (non visible sur la figure dans laquelle les proportions en épaisseur ont sensiblement été respectées). On voit que la glace supérieure 1 présente une extension 7 supportant sur sa surface inférieure les pistes des électrodes. Un circuit imprimé 20, supportant comme composant électroniques par exemple une capa 12, un chip 14 et un quartz 16, est positionné sous ladite extension 7 en mettant en regard des pistes les zones de contact du PCB pour créer une zone de connexion 6.. On applique ensuite sur la zone de connexion 6 un faisceau laser 30 à travers l'extension 7 de la glace 1 pour établir la connexion définitive.

La figure 2 concerne un mode de réalisation dans lequel le PCB est positionné sous le LCD. La cellule d'affichage LCD 10 est comparable à celle décrite à la figure 1, mais la glace supérieure 1 comporte deux extensions 7 et 9 qui permettront d'établir deux zones de connexion avec le PCB 20 sous-jacent. On voit également que le PCB 20 comporte un évidemment 19, qui permet de loger la glace inférieure 3 et le réflecteur 4, de façon à ce que les bords de cet évidemment viennent affleurer les surfaces inférieures des extensions 7, 9 supportant les pistes des électrodes. De façon avantageuse le fond de l'évidemment 19 est garni d'une colle 18 permettant d'effectuer un pré-assemblage, sans faire appel par exemple à une matrice d'assemblage. Avec cette construction il est possible de focaliser le faisceau laser 30 en incidence rasante sur les zones de connexion 6.8.

Pour les exemples qui viennent d'être décrits, avec les dimensions d'une cellule d'affichage dans une montre à affichage analogique l'expérience a montré que le temps nécessaire pour former la connexion pouvait être ramené de 10-12s à 1-3s, ce qui constitue un avantage économique non négligeable.

On observera également que le mode de réalisation permet d'appliquer le procédé selon l'invention à un affichage comportant plusieurs cellules superposées simplement en décalant en escalier les zones de connexion.

La présente invention n'est pas limitée au mode de réalisation qui vient d'être décrit et l'homme de métier peut trouver d'autres applications sans sortir du cadre de la présente invention telle que définie dans la revendication.

## Revendications

1. Procédé de connexion d'un circuit imprimé (PCB) (20) aux pistes des électrodes d'une cellule d'affichage à cristaux liquides (LCD) (10) comportant une glace supérieure (1) orientée vers un observateur, une glace inférieure (3) et un cadre de scellement (5) permettant de confiner lesdits cristaux liquides, le procédé consistant en les étapes suivantes
- construire la cellule d'affichage (10) avec au moins deux extensions (7, 9) de la glace supérieure (1) pour supporter sur sa surface inférieure les pistes des électrodes;
- créer une zone de connexion (6) en positionnant le PCB (20) sous la glace inférieure (3) du LCD (10) et lesdites extensions sur des contacts en regard du PCB (20) sans apport de matière, la glace inférieure (3) du LCD (10) étant logée dans un évidement (19) pratiqué dans le PCB (20), les bords dudit évidement (19) venant affleurer la surface inférieure de la glace supérieure (1) du LCD (10) et,
- focaliser un faisceau laser (30) sur la zone de connexion à travers la glace supérieure ou en incidence rasante par rapport à la surface inférieure de la glace supérieure (1).

## Claims

1. Method for connecting a printed circuit board (PCB) (20) to the paths of the electrodes of a liquid crystal display cell (LCD) (10) comprising a upper plate (1), directed towards observer lower plate (3) and a sealing frame (5) for confining said liquid crystal, the method comprising the following steps:
- constricting the display cell (10) with at least two extensions (7, 9) of the upper plate (1) to support the electrode paths on its lower surface;
- creating a connection zone (6) by positioning the PCB (20) under the lower plate (3) of the LCD (10) and said extensions on contacts facing the PCB (20) without adding material the lower plate of the LCD is housed in a recess made in the PCB, the edges of said recess being flush with the lower surface of the upper plate of the LCD and,
- focussing a laser beam (30) on the connection zone, through the upper plate or in grazing incidence with respect to the lower surface of the upper plate (1).

## Patentansprüche

1. Verfahren zum Anschließen einer gedruckten Schaltung (PCB) (20) an die Elektrodenbahnen einer Flüssigkristallaiizeigezelle (LCD) (10), die ein oberes Glas (1), das zu einem Beobachter orientiert ist, ein unteres Glas (3) und einen Einkapselungsrahmen (5), der ermöglicht, die Flüssigkristalle einzuschließen, umfasst, wobei das Verfahren aus den folgenden Schritten besteht:
- Ausbilden der Anzeigezelle (10) mit wenigstens zwei Verlängerungen (7, 9) des oberen Glases (1), um auf seiner unteren Oberfläche die Elektrodenbahnen zu unterstützen;
- Erzeugen einer Anschlusszone (6) durch Positionieren der PCB (20) unter dem unteren Glas (3) der LCD (10) und der Verlängerungen auf den Kontakten gegenüber der PCB (20) ohne Materialeintrag, wobei sich das untere Glas (3) der LCD (10) in einer Aussparung (19) befindet, die in der PCB (20) ausgebildet ist, wobei die Ränder der Aussparung (19) mit der unteren Oberfläche des oberen Glases (1) der LCD (10) glatt abschießen, und
- Fokussieren eines Laserstrahlenbündels (30) auf der Anschlusszone durch das obere Glas oder unter streifendem Einfall in Bezug auf die untere Oberfläche des oberen Glases (1).
